# EUROPÄISCHE PATENTSCHRIFT

(11) **EP 2 994 020 B1**
(45) Veröffentlichungstag und Bekanntmachung des Hinweises auf die Patenterteilung: **08.07.2020**
(21) Anmeldenummer: 14723438.9
(22) Anmeldetag: 12.05.2014
(51) Int. Cl.: A47C 20/04, A47C 31/00, H03K 17/96

(54) **HANDBEDIENUNG FÜR EINEN ELEKTROMOTORISCHEN MÖBELANTRIEB, VERFAHREN ZUM ERFASSEN EINER BETÄTIGUNG EINER HANDBEDIENUNG, UND EIN ELEKTROMOTORISCHER MÖBELANTRIEB**
HAND-HELD CONTROL FOR AN ELECTOMOTIVE FURNITURE DRIVE, METHOD FOR DETECTING ACTUATION OF A HAND-HELD CONTROL, AND ELECTROMOTIVE FURNITURE DRIVE
COMMANDE MANUELLE POUR UN MÉCANISME D'ENTRAINEMENT DE MEUBLE À MOTEUR ÉLECTRIQUE, PROCÉDÉ DE DÉTECTION D'UN ACTIONNEMENT D'UNE COMMANDE MANUELLE ET MÉCANISME D'ENTRAINEMENT DE MEUBLE

(30) Priorität: 10.05.2013 DE 102013104827
(43) Veröffentlichungstag der Anmeldung: 16.03.2016
(73) Patentinhaber: DewertOkin GmbH, 32278 Kirchlengern (DE)
(72) Erfinder: HILLE, Armin, 33659 Bielefeld (DE)
(74) Vertreter: Kleine, Hubertus
(86) Internationale Anmeldenummer: PCT/EP2014/059665
(87) Internationale Veröffentlichungsnummer: WO 2014/180998

(56) Entgegenhaltungen:
- EP-A1- 2 581 073
- WO-A2-2012/061406
- US-A1- 2003 195 644
- US-A1- 2010 292 945
- US-A1- 2011 156 930
- US-A1- 2011 245 979
- US-A1- 2012 118 718

## Beschreibung

Die Erfindung betrifft eine Handbedienung für einen elektromotorischen Möbelantrieb. Die Erfindung bezieht sich weiterhin auf ein Verfahren zum Erfassen einer Betätigung einer Handbedienung, sowie auf einen elektromotorischen Möbelantrieb.

Derartige Handbedienungen kommen beispielsweise zur Bedienung von elektromotorischen Möbelantrieben zur Verstellung von Möbeln, wie z.B. Betten, Sessel u.dgl., zum Einsatz (siehe z.B. US 2012/0118718 A1 und WO 2012/061406 A2).

Ein solcher elektromotorischer Möbelantrieb ist in einem Möbel angebracht, welches feste und bewegliche Möbelbauteile aufweist. Feste Möbelbauteile sind z.B. Rahmenbauelemente. Bewegliche Möbelbauteile sind z.B. feste oder federnachgiebige Stützflächen einer Polsterung oder einer Matratze des Sitz- und/oder Liegemöbels oder tragende Holme zur Aufnahme der Stützflächen.

Der elektromotorische Möbelantrieb dient zur Verstellung der beweglichen Möbelbauteile. Dabei wird die von dem elektromotorischen Möbelantrieb erzeugte Verstellbewegung und Antriebskraft auf das jeweilige bewegliche Möbelbauteil übertragen, wobei sich der elektromotorische Möbelantrieb an einem festen Möbelbauteil abstützt und das bewegliche Möbelbauteil relativ zu dem festen Möbelbauteil verstellt. Der elektromotorische Möbelantrieb kann auch zwischen zwei beweglichen Möbelbauteilen angebracht sein, wobei er diese relativ zueinander verstellen kann.

Es sind drahtgebundene als auch drahtlose Handbedienungen bekannt. Einige drahtlose Handbedienungen weisen eine infrarote Übertragungsstrecke oder eine Funkübertragungsstrecke auf. Andere Handbedienungen weisen ein Gehäuse und Bedienflächen auf, welche als Tastschalter oder als Touchscreen ausgebildet sind.

Die DE 297 22 179 U offenbart einen Handschalter mit einem Touchscreen als Bedienfläche. Als Nachteil hat sich heraus gestellt, dass die Auswertung dieses resistiven Touchscreen relativ aufwendig ist.

Die DE 94 14 086 U offenbart eine Handbedienung mit Tastknöpfe, welche mechanisch betätigend auf Mikroschalter innerhalb des Gehäuses der Handbedienung einwirken. Als Nachteil dieses Standes der Technik haben sich aus Designgründen die hervorstehenden und mechanisch beweglichen Tastknöpfe herausgestellt.

Elektromotorische Möbelantriebe sind aus dem Stand der Technik in einer Vielzahl von unterschiedlichen Ausführungen für unterschiedliche Einsatzfälle und Zwecke bekannt.

Aus dem Grund ist man teilweise dazu übergegangen, Folienschalter oder flache Schnappschalter zu verwenden. Es gibt jedoch Anforderungen, wobei das haptische Durchdrücken und die Betätigung durch Folienschalter unerwünscht sind. Ferner ist das Durchleuchten dieser und der eingangs genannten Schalter schwierig und mit einem erhöhten Bauteilaufwand verbunden.

Elektromotorische Möbelantriebe sind in vielen unterschiedlichen Ausführungen, z.B. als Einzelantriebe, Doppel- und Mehrfachantriebe, im Einsatz.

Der Erfindung liegt die Aufgabe zu Grunde, eine verbesserte Handbedienung bereit zu stellen, welche die eingangs genannten Nachteile nicht mehr aufweist.

Eine weitere Aufgabe der Erfindung ist es, ein verbessertes Verfahren zum Erfassen einer Betätigung einer Handbedienung anzugeben.

Eine noch weitere Aufgabe besteht darin, einen verbesserten elektromotorischen Möbelantrieb zu schaffen.

Die Aufgabe wird durch eine Handbedienung mit den Merkmalen des Anspruchs 1 gelöst.

Die weitere Aufgabe wird durch ein Verfahren mit den Merkmalen des Anspruchs 6 gelöst.

Die noch weitere Aufgabe wird durch einen elektromotorischen Möbelantrieb mit den Merkmalen des Anspruchs 12 gelöst.

Eine Handbedienung ist mit einem Bedienfeldabschnitt vorgesehen, wobei der Bedienfeldabschnitt eine feste, nicht nachgiebige Oberfläche aufweist und der Bedienfeldabschnitt berührungsempfindliche Betätigungsflächen aufweist, welche in einem vorbestimmten Abstand zueinander angeordnet sind und jede Betätigungsfläche mit wenigstens einem Detektor in Verbindung steht.

Demgemäß weist eine erfindungsgemäße Handbedienung für elektromotorische Möbelantriebe mindestens einen Bedienfeldabschnitt auf, wobei der mindestens eine Bedienfeldabschnitt mindestens eine Betätigungsfläche aufweist, wobei die mindestens eine Betätigungsfläche mit wenigstens einem Detektor zusammenwirkt.

Ein erfindungsgemäßes Verfahren zum Erfassen einer Betätigung einer solchen Handbedienung weist folgende Verfahrensschritte auf. (V1) Beaufschlagen wenigstens einer Sensorfläche wenigstens eines Detektors mit einem elektrischen, periodischen Testsignal von wenigstens einer Auswerteeinheit; (V2) Aufnehmen eines Antwortsignals anhand eines durch Betätigung des wenigstens einen Detektors veränderten Testsignals; und (V3) Auswerten des so erhaltenen Testsignals und Erzeugen eines logischen Schaltsignals zum Erfassen der Betätigung der Handbedienung.

Die Funktion ist denkbar einfach und wie folgt:
Nähert sich zur Auslösung einer Schaltfunktion ein Finger einer Betätigungsfläche, oder berührt ein Finger eine Betätigungsfläche, wird dies vom Detektor als kapazitive Änderung der Betätigungsfläche relativ zu einem Referenzwert detektiert, so dass die damit verbundene Auswerteinheit ein Schaltsignal für eine beabsichtigte Funktion, z.B. eine Verstellung eines elektromotorischen Möbelantriebs, erzeugt.

Demgemäß ist ein elektromotorischer Möbelantrieb mit mindestens einer oben beschriebenen Handbedienung zur Bedienung ausgerüstet ist, wobei eine Betätigung der Handbedienung durch das oben beschriebene Verfahren erfolgt.

Erfindungsgemäß ist jeder Betätigungsfläche ein Detektor zugeordnet, welcher im Inneren des Gehäuses der Handbedienung angeordnet ist. Unter einem Detektor ist eine Erfassungseinrichtung zu verstehen, welche eine Annäherung oder/und Berührung eines Fingers einer menschlichen Hand in Zusammenwirkung mit der Betätigungsfläche erfasst und dabei ein elektrisches Signal ausgibt.

Erfindungsgemäß weist der mindestens eine Bedienfeldabschnitt mehrere Betätigungsflächen auf, welche in einem vorbestimmten Abstand zueinander angeordnet sind.

Erfindungsgemäß wird die mindestens eine Betätigungsfläche mit dem wenigstens einen Detektor so zusammen, dass die mindestens eine Betätigungsfläche mindestens eine berührungsempfindliche Funktion aufweist. So kann der Detektor z.B. als kapazitiver Näherungsdetektor ausgebildet sein.

In einer anderen Ausführungsform ist der Detektor als kapazitiver Näherungsschalter ausgebildet.

Erfindungsgemäß ist vorgesehen, dass der mindestens eine Bedienfeldabschnitt eine feste, nicht nachgiebige Oberfläche aufweist. Dadurch ist es möglich, dass unterschiedlich Oberflächen Verwendung finden können.

Dabei kann die Oberfläche der Handbedienung erfindungsgemäß selbst den mindestens einen Bedienfeldabschnitt aufweisen.

Die Betätigungsflächen wirken wie Tastbetätiger, d.h. Betätiger von elektrischen Tastern, jedoch ist die Oberfläche des Bedienfeldes unnachgiebig und weist keine federnden Abschnitte auf.

Als nicht nachgiebige Oberflächenabschnitte bzw. als keine federnden Abschnitte sind solche Abschnitte definiert welche im Rahmen des bestimmungsgemäßen Gebrauchs der Handbedienung keine erkennbare nachgiebige Eigenschaft aufweisen. Bei einem bestimmungsgemäßen Gebrauch der Handbedienung werden die Betätigungsflächen entweder berührt oder alternativ mit einem Fingerdruck mit einer Kraftbeaufschlagung von bis zu 10 Newton berührt bzw. darauf eingewirkt. Als eine weitere Form der Berührung kann auch ein nahezu Berühren verstanden werden, wenn das Erkennen eines sich der Betätigungsfläche annähernden Fingers bereits bei einem Abstand von wenigen zehntel Millimetern erfolgt.

Ein Detektor kann ferner als integrierter Schaltkreis (IC) ausgebildet sein.

Ein Detektor kann alternativ als elektrischer Leiter ausgebildet sein, welcher mit einer Auswerteeinheit, beispielsweise in Form eines integrierten Schaltkreises, elektrisch leitend verbunden ist. Es sind natürlich auch optische Übertragungen möglich, z.B. Lichtleiter.

Alternativ kann ein Detektor mehrere elektrische Leiter aufweisen. Andere Detektoren weisen zwei elektrische Leiter auf. Wieder andere Detektoren weisen wenigstens einen elektrischen Leiter auf, wobei wenigstens ein erster Leiter das berührungsempfindliche Detektionssignal zur Auswerteeinheit führt und wenigstens ein weiterer Leiter dem ersten Leiter zugeordnet ist. Ferner können mehrere Detektoren einen oder mehrere gemeinsame Leiter aufweisen. Es können alternativ auch mehrere Detektoren zu Gruppen zusammen gefasst sein, wenn sie einen gemeinsamen Leiter zur Verbindung mit der Auswerteinheit oder alternativ einen weiteren gemeinsamen Leiter aufweisen. Der weitere gemeinsame Leiter kann als Referenz bzw. als Referenzwertgeber dienen, wie unten näher erläutert wird.

Erfindungsgemäß weist die Handbedienung eine Detektorplatine mit dem wenigstens einem Detektor auf. Eine solche Platine ist kostengünstig herstellbar und an viele unterschiedliche Gehäuse anpassbar.

Erfindungsgemäß ist vorgesehen, dass der wenigstens eine Detektor wenigstens eine Sensorfläche umfasst, der wenigstens eine Massefläche zugeordnet ist. In vorteilhafter Weise können sowohl die Sensorfläche als auch die Massefläche als Leiter der Leiterplatte aufgebaut sein.

Die wenigstens eine Sensorfläche kann als ein rechteckiger, insbesondere quadratischer, erfindungsgemäß elektrisch leitender Rahmen ausgebildet sein. Natürlich sind auch andere Formen möglich. Diese Formen haben sich bereits in Versuchen erfolgreich bewährt und sind leicht zu realisieren.

Erfindungsgemäß ist vorgesehen, dass die wenigstens eine Sensorfläche mit der wenigstens einen zugeordneten Massefläche mit wenigstens einer Auswerteeinheit elektrisch leitend verbunden ist.

Die Auswerteeinheit kann ein Mikroprozessor sein, welcher Schalt- und Steuersignale für eine Übertragungsstrecke erzeugt. Mittels der Übertragungsstrecke ist die Handbedienung mit dem Möbel und/oder mit dem Möbelantrieb verbunden. Die Übertragungsstrecke ist vorzugsweise als drahtlose Funkstrecke und alternativ als drahtbehaftete Kabelverbindung ausgebildet.

Wenigstens einem Detektor ist ein Referenzwertgeber zugeordnet. Ein solcher Referenzgeber kann vorteilhaft die wenigstens eine Massefläche sein. Alternativ weist das Gehäuse eine Referenzeinrichtung auf. Diese kann als Leiter ausgebildet sein. Alternativ kann die Referenzeinrichtung an der Oberfläche der Handbedienung angebracht oder ferner zumindest in der Oberfläche stoffschlüssig eingebracht sein. Eine weitere Alternative sieht eine Referenzeinrichtung an den Stellen der Handbedienung vor, welcher üblicherweise beim Halten in der Hand von den Fingern oder Abschnitten der Hand berührt werden.

Außerdem kann eine Leuchte, z.B. eine LED, vorgesehen sein, wodurch die Handbedienung auch eine Taschenlampenfunktion erhält.

In einer besonders vorteilhaften Ausführungsform sind weitere Leuchtmittel, beispielsweise als LED ausgebildet, zur Beleuchtung wenigstens einer Betätigungsfläche vorgesehen. Das Einschalten der Leuchtmittel erfolgt auf verschiedene Weise, wenigstens jedoch bei Betätigen einer Betätigungsfläche. Dazu weist die Auswerteeinheit einen Schaltausgang zur Ansteuerung oder zur Schaltung der Leuchtmittel auf. Alternativ ist am Gehäuseumfang der Handbedienung eine weitere Betätigungsfläche angeordnet, welche zur Auslösung des Schaltbefehls des Einschaltens der Leuchtmittel vorgesehen ist. Andere Ausführungen weisen eine eigens gekennzeichnete Betätigungsfläche zumindest für das Einschalten der Leuchtmittel auf. Andere Ausführungen weisen noch einen Schalter oder Detektor auf, welcher das Ergreifen der Handbedienung erkennt und beispielsweise als Rüttelsensor oder als Beschleunigungssensor ausgebildet ist, welcher das Signal zum einschalten der Leuchtmittel erkennt.

Eine Ausführung der Handbedienung weist eine bei Tageslicht erkennbare Symbolik oder andere Kennzeichnungen der Betätigungsflächen auf. Ferner kann die Handbedienung mit einem lichtempfindlichen Sensor ausgestattet sein, welcher das Einschalten der Leuchtmittel bei ausreichender Umgebungsbeleuchtung unterbindet, wenn es sich um eine batteriebetriebene Handbedienung handelt.

Eine weitere Ausführung der Handbedienung weist Symbole oder andere Kennzeichnungen der Betätigungsflächen auf, welche nur bei Einschalten der Leuchtmittel zu erkennen sind. Eine weitere Ausführungsform einer Handbedienung weist eine vorbestimmte Anzahl der Symbolik oder anderer Kennzeichnungen der Anzahl der vorbestimmten Betätigungsflächen auf, wenn diese nur in besonderen Betriebsmodi zum Vorschein und zur Benutzung kommen sollen. Somit kann auch auf sehr einfache Weise das Einblenden weiterer Betätigungsflächen erfolgen, wenn diese beispielsweise zum Einprogrammieren von Höhen- oder Winkelverstellpositionen des Möbels oder zum Einprogrammieren der Uhrzeit oder dergleichen Verwendung finden soll. Somit wird auf einfache Art und Weise der Bedienkomfort bedeutend erhöht, wenn sich der Benutzer nur auf die wichtigsten Bedienflächen konzentrieren kann.

Die Anordnung der Leuchtmittel ist insbesondere im Inneren der Handbedienung vorgesehen. Die Vorderseite bzw. die Bedienungsseite ist dabei durchleuchtbar ausgebildet.

Erfindungsgemäß weist die wenigstens eine Sensorfläche ein Durchgangsloch auf, welches sie wenigstens teilweise umgibt. Dies ist ein kompakter und Platz sparender Aufbau.

Alternativ sind nur die Betätigungsflächen durchleuchtbar ausgebildet. Eine andere Ausführungsform sieht Leuchtmittel vor, welche scheinbar in der Vorderseite bzw. in der Bedienungsseite eingesetzt sind. Dazu sind die Leuchtmittel an der Oberfläche der Vorderseite angebracht. In vorteilhafter Ausgestaltung sind sie an der Innenseite der Vorderseite angeordnet. Ferner kann eine Betätigungsfläche selbst auch das Leuchtmittel aufweisen, wenn es mit der Betätigungsfläche eine Einheit bildet und entweder an der Betätigungsfläche angebracht ist oder mit ihr in dichter räumlicher Verbindung steht. Ferner kann die Symbolik selbst als Leuchtmittel ausgebildet sein.

Eine noch weitere Ausführung der Handbedienung sieht vor, dass die wenigstens eine Sensorfläche von der wenigstens einen Massefläche wenigstens teilweise vollständig umgeben ist. Ein solches vollständiges Umgeben kann alle Seiten der Sensorfläche, auch von der anderen Leiterplattenseite her einschließen. Dabei wird vorteilhaft einfach eine Referenzfläche geschaffen.

Weiterhin weist die wenigstens eine Massefläche wenigstens ein mit einem Rand umgebenes Kreuzmuster auf. Es hat sich hier anhand vieler Versuche herausgestellt, dass dadurch überraschenderweise eine Beeinflussung von unterschiedlichen Störungen vermindert werden kann.

In einer noch anderen Ausführung weist die die Handbedienung wenigstens eine Steuereinrichtung zur Erzeugung eines Steuersignals auf. Die Steuereinrichtung kann auch zusätzliche Auswerteaufgaben der Antwortsignale übernehmen, wodurch eine Störfestigkeit erhöht werden kann.

In einer Ausführung des erfindungsgemäßen Verfahrens wird in dem dritten Verfahrensschritt (V3) Auswerten aus dem Antwortsignal direkt ein logisches Schaltsignal gebildet. Damit können zusätzlich Auswerteroutinen eingespart werden. Andererseits ist es aber möglich, dieses so gebildete Schaltsignal zur Erhöhung einer Bedienungssicherheit für andere Auswertprozesse heranzuziehen.

In einer Variante vergleicht in dem dritten Verfahrensschritt (V3) Auswerten die wenigstens eine Auswerteeinheit alle Antwortsignale, wobei das Antwortsignal mit dem höchsten Signalpegel zur Weiterleitung an eine Steuereinrichtung der Handbedienung verwertet wird.

Alternativ oder zusätzlich kann in dem dritten Verfahrensschritt (V3) Auswerten die wenigstens eine Auswerteeinheit einen Ausgabewert korrespondierend mit dem Signalpegel des Antwortsignals an eine Steuereinrichtung weiterleiten.

In einer anderen Ausführung kann die Steuereinrichtung bei mehreren aufgenommenen gleichen oder ähnlichen Antwortsignalen geometrische Anordnung der Sensorflächen, welche die Antwortsignale geliefert haben, berücksichtigen, wobei die geometrisch am nächsten gelegene Sensorfläche als diejenige festgelegt wird, deren Funktion ein Bediener beabsichtigt hat.

In noch einer anderen Ausführung ist vorgesehen, dass eine Höhe des Signalpegels des Antwortsignals einer jeweiligen Sensorfläche eines Detektors einer zugehörigen Betätigung vorher zugeordnet wird.

Es hat sich bei Versuchsreihen mit der erfindungsgemäßen Handbedienung und dem erfindungsgemäßen Verfahren überraschenderweise herausgestellt, dass durch den Aufbau und das Verfahren einerseits eine Störanfälligkeit der kapazitiven Detektoren bedeutend vermindern und eine Zuverlässigkeit der Funktion erheblich erhöht.

Anhand der beigefügten Zeichnungen wird die Erfindung näher erläutert. Es zeigen:
- Figur 1: eine schematische Draufsicht auf ein erstes Ausführungsbeispiel einer erfindungsgemäßen Handbedienung;
- Figur 2: eine perspektivische, fotorealistische Darstellung des ersten Ausführungsbeispiels nach Figur 1;
- Figur 3: fotorealistische Ansichten einer Variante des ersten Ausführungsbeispiels nach Figur 1;
- Figur 4: eine schematische Draufsicht auf ein zweites Ausführungsbeispiel der erfindungsgemäßen Handbedienung;
- Figur 5: fotorealistische Ansichten einer Variante des zweiten Ausführungsbeispiels nach Figur 4;
- Figur 6: eine schematische Draufsicht auf ein drittes Ausführungsbeispiel der erfindungsgemäßen Handbedienung;
- Figur 7: eine perspektivische, fotorealistische Darstellung des dritten Ausführungsbeispiels nach Figur 6;
- Figur 8: eine schematische Draufsicht auf eine Betätigungsseite einer Detektorplatine;
- Figur 9: eine schematische Draufsicht auf eine Bestückungsseite der Detektorplatine nach Figur 8;
- Figur 10: eine vergrößerte Darstellung eines Ausschnitts X einer Massefläche nach Figur 8;
- Figur 11: eine schematische Draufsicht auf eine Oberseite einer Steuerplatine;
- Figur 12: eine schematische Draufsicht auf eine Bestückungsseite der Steuerplatine nach Figur 10;
- Figur 13: ein schematisches Flussdiagramm eines erfindungsgemäßen Verfahrens; und
- Figur 14: eine schematische Perspektivdarstellung eines Ausführungsbeispiels einer Handbedienung mit einem beispielhaften Möbel.

Die Begriffe "oben", "unten", "links" und "rechts" beziehen sich jeweils auf die jeweiligen Anordnungen in den Darstellungen der Figuren.

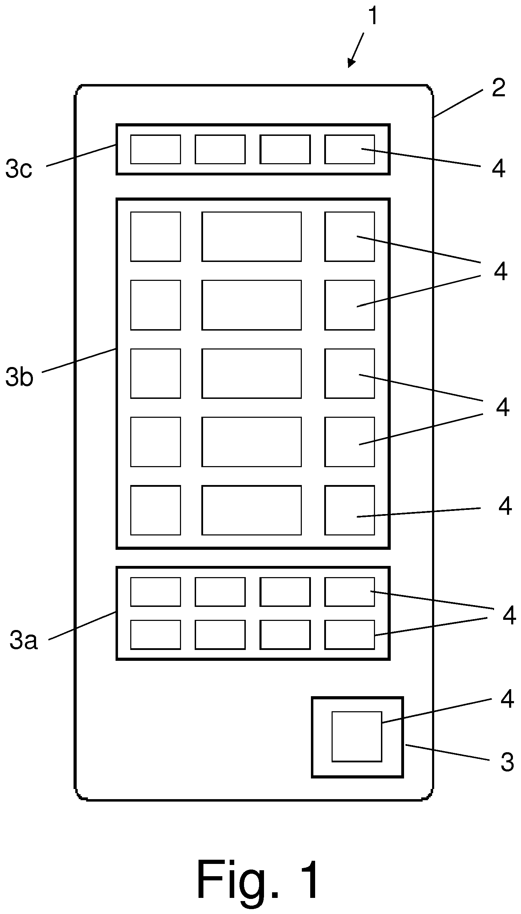

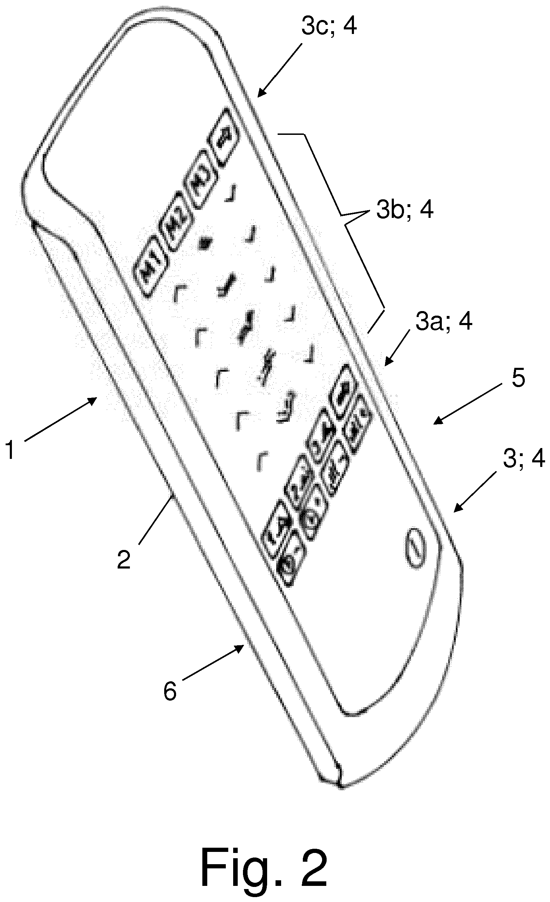

Figur 1 zeigt eine schematische Draufsicht auf ein erstes Ausführungsbeispiel einer erfindungsgemäßen Handbedienung 1. In Figur 2 ist eine perspektivische, fotorealistische Darstellung des ersten Ausführungsbeispiels nach Figur 1 dargestellt.

Die Handbedienung 1 weist ein Gehäuse 2 mit einer Vorderseite 5 und einer Rückseite 6 auf. Die Vorderseite 5 ist mit einer Anzahl Bedienfeldabschnitten 3, 3a, 3b, 3c versehen. Der kleine Bedienfeldabschnitt 3 weist eine Betätigungsfläche 4 auf und dient z.B. als Einschalter. Die weiteren Bedienfeldabschnitte 3a, 3b, 3c weisen eine Mehrzahl Betätigungsflächen 4 mit unterschiedlicher Symbolik für unterschiedliche Bedienfunktionen auf.

Die Handbedienung 1 ist mit einer elektrischen Energiequelle ausgerüstet, die sich im Inneren des Gehäuses 2 befindet. Die elektrische Energiequelle kann eine Batterie, eine wieder aufladbare Batterie oder ein Akkumulator sein. Die elektrische Energiequelle kann austauschbar sein, wobei für sie ein durch einen Deckel verschließbares Fach angeordnet ist, z.B. von der Rückseite 6 her zugänglich. Es ist auch möglich, dass die elektrische Energiequelle in wieder aufladbarer Ausgestaltung in dem Gehäuse 2 eingeschlossen ist, wobei ein Wechsel derselben nur mittels Werkzeug oder durch Zerstörung des Gehäuses 2 möglich ist. Eine Aufladung der wieder aufladbaren elektrischen Energiequelle kann durch einen Anschluss, z.B. eine Steckverbindung, oder über eine drahtlose Induktionseinrichtung erfolgen.

Ferner kann die Oberfläche der Handbedienung 1 eine Anzahl elektrisch leitender Berührungskontakte aufweisen, welche zur Aufnahme und zur Übertragung von elektrischer Energie zur Aufladung der im Gehäuse 2 angeordneten elektrischen Energiequelle ausgeführt sind.

Gemäß diesem ersten Ausführungsbeispiel sind einzelne Betätigungsflächen 4 lichtdurchlässig ausgebildet und mittels einer Lichtquelle im Inneren des Gehäuses 2 durchleuchtbar ausgebildet. Alternativ sind Betätigungsflächen auf der Außenseite der Handbedienung mit Symbolik oder mit Beschriftung beklebt, bedruckt oder es ist eine ertastbare Struktur an der Oberfläche, beispielsweise in Form von Blindenschrift, vorgesehen.

Die Betätigungsflächen 4 wirken wie Tastbetätiger, d.h. Betätiger von elektrischen Tastern, jedoch ist die Oberfläche der Vorderseite 5 des gesamten Bedienfeldes (aller Bedienabschnitte 3) unnachgiebig und weist keine federnden Abschnitte auf. Die Oberfläche kann z.B. aus Glas hergestellt sein.

An dieser Stelle sei noch einmal die federnde Nachgiebigkeit angemerkt, welche als Eigenschaft selbst dem Werkstoff Glas zugewiesen werden kann. Jeder Werkstoff weist ein gewisses Maß an federnder, elastischer oder plastischer Nachgiebigkeit auf. Bezogen auf die vorliegende Erfindung ist ein gewisses Maß an federnder Nachgiebigkeit immer im Rahmen von wenigen Zehntel Millimetern, beispielsweise von wenigstens einem Zehntel Millimeter gegeben, wenn sich Fingerdruckkräfte auf die Oberfläche der Vorderseite 5 erstrecken, die außerhalb des bestimmungsgemäßen Gebrauchs der Handbedienung beispielsweise Fingerdruckkräfte von mehr als 250 Newton auf die Vorderseite einwirken.

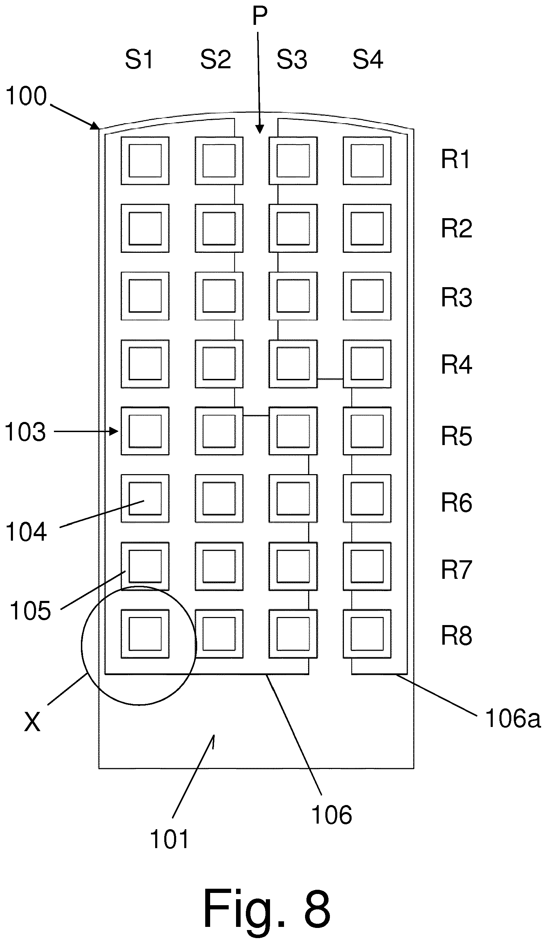

In einer ersten Ausführung ist jeder Betätigungsfläche 4 ein Detektor 103 (siehe Figur 8) zugeordnet, welcher im Inneren des Gehäuses 2 der Handbedienung 1 angeordnet ist. Unter einem Detektor 103 ist in einer Ausführung eine Erfassungseinrichtung zu verstehen, welche eine Annäherung oder/und Berührung eines Fingers einer menschlichen Hand in Zusammenwirkung mit der Betätigungsfläche erfasst und dabei ein elektrisches Signal ausgibt, welches durch eine sich anschließende Elektronik beispielsweise einer Auswerteinheit verarbeitet wird und für eine Übertragung, z.B. an eine Steuervorrichtung eines elektromotorischen Möbelantriebs, vorgesehen ist. Dies wird unten noch weiter erläutert.

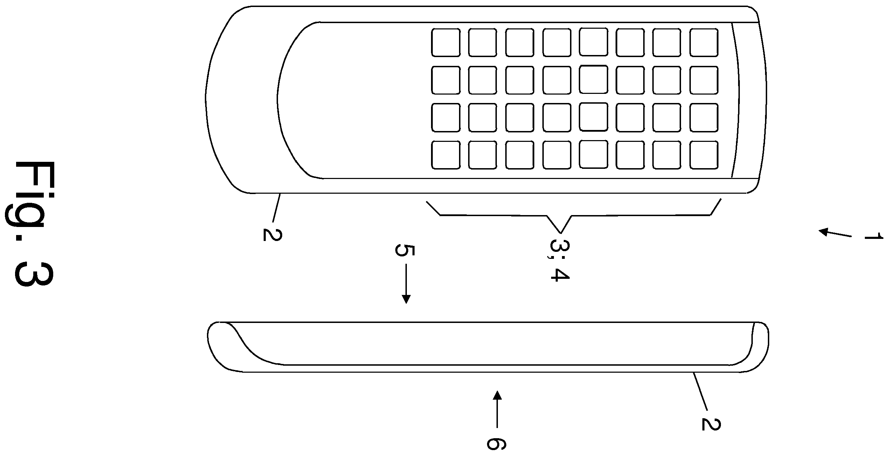

In Figur 3 sind fotorealistische Ansichten einer Variante des ersten Ausführungsbeispiels nach Figur 1 gezeigt. Die linke Seite der Figur 3 stellt eine Draufsicht auf die Vorderseite 5 dar, die rechte Seite zeigt eine Seitenansicht.

In dieser Variante ist nur ein Bedienfeldabschnitt 3 mit zweiunddreißig (32) Bedienungsflächen 4 vorgesehen. Eine Symbolik ist noch nicht aufgebracht.

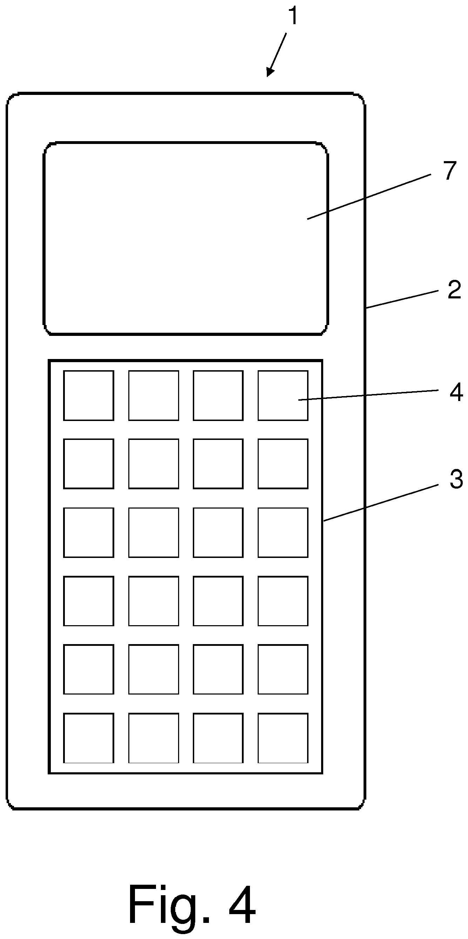

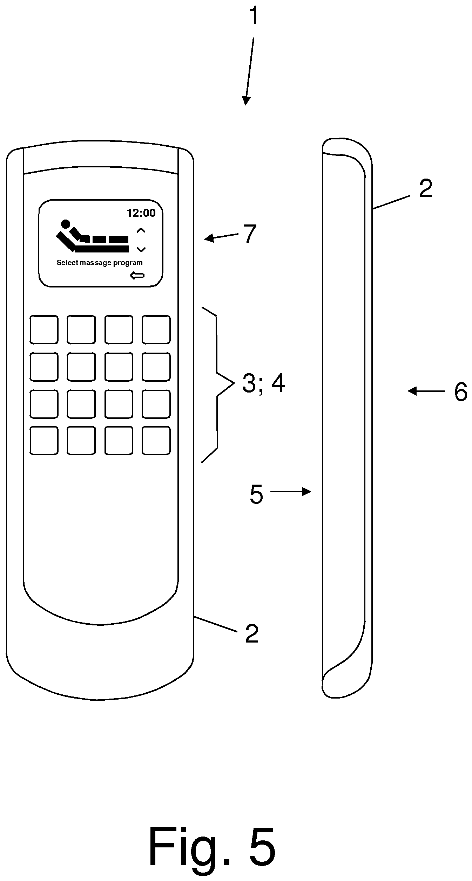

Die Figur 4 zeigt eine schematische Draufsicht auf ein zweites Ausführungsbeispiel der erfindungsgemäßen Handbedienung 1. In Figur 5 sind fotorealistische Ansichten einer Variante des zweiten Ausführungsbeispiels nach Figur 4 dargestellt.

Die Handbedienung 1 ist wie eingangs beschrieben aufgebaut, weist jedoch zusätzlich eine Anzeigeeinrichtung (Display) 7 auf. Gemäß der Ausführung dieser Figur 4 ist nur ein Bedienfeldabschnitt 3 vorgesehen, welcher vierundzwanzig (24) bzw. sechzehn (16) Betätigungsflächen 4 aufweist. Jede Betätigungsfläche 4 ist symbolisch mit einer Umrandung gezeigt. Sie stehen in einem vorbestimmten Abstand zueinander. Dieser vorbestimmte Abstand entspricht dem Abstand der Detektoren 103 im Inneren des Gehäuses 2 der Handbedienung 1.

Es sei noch angemerkt, dass alle in den Figuren dargestellten sogenannten Umrandungen der Betätigungsflächen 4 vorzugsweise zur besseren Verdeutlichung sowohl der Größe als auch der Anordnung der Betätigungsflächen 4 dienen sollen. Das Anbringen oder Kennzeichnen der Betätigungsflächen 4 an oder mit der Vorderseite 5 ist je nach Ausführung der Handbedienung 1 verwirklicht.

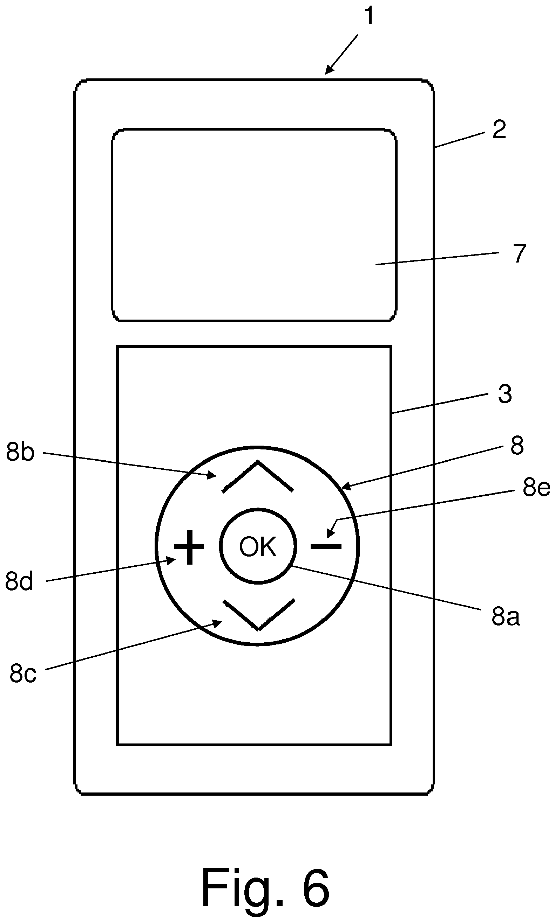

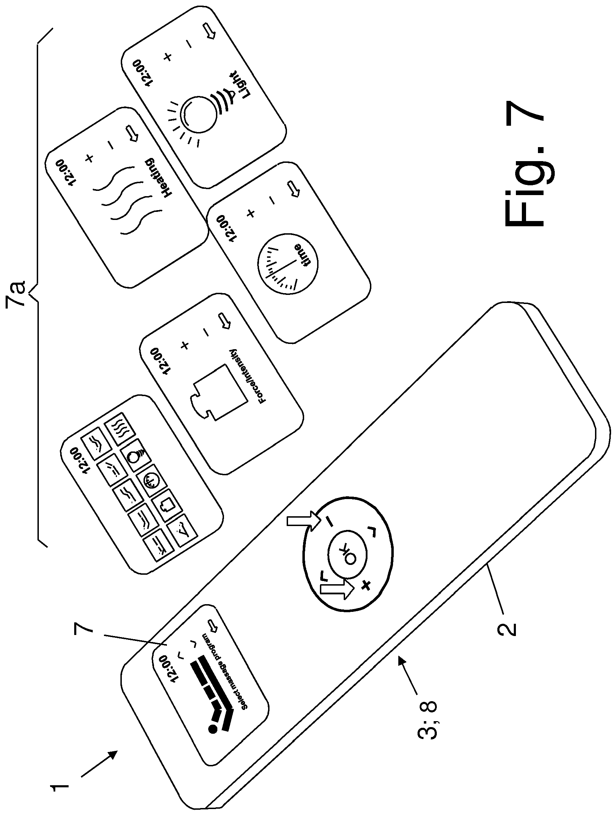

Figur 6 zeigt eine schematische Draufsicht auf ein drittes Ausführungsbeispiel der erfindungsgemäßen Handbedienung 1; und Figur 7 stellt eine perspektivische, fotorealistische Darstellung des dritten Ausführungsbeispiels nach Figur 6 dar.

Die Figur 6 zeigt eine Handbedienung 1 mit einer Anzeigeeinrichtung 7 und einem Bedienfeldabschnitt 3 bestehend aus einer hier beispielhaften kreisrunden Betätigungsfläche 8 mit fünf einzelnen, separaten Betätigungsflächen 8a...8e. Dabei sind vier Betätigungsflächen 8b, 8c, 8d, 8e im selben Abstand und kreisförmig um eine zentrale Betätigungsfläche 8a angeordnet.

Die Funktion ist wie folgt: Mittels zweier Menübetätiger 8c, 8d kann das Menü der Anzeigeeinrichtung 7 umgeschaltet werden. Zwei weitere Schaltflächen als Funktionsbetätiger 8b, 8c betätigen die ausgewählte Funktion. Eine vorbestimmte Schaltfläche als Quittungsbetätiger 8a bildet eine logische Auswahl- und Bestätigungsfunktion der Bedienbarkeit der Handbedienung 1.

In Figur 7 sind weiterhin beispielhafte Anzeigemuster 7a gezeigt, welche zur Bedienung und Information von der Anzeigeeinrichtung 7 dargestellt werden können.

Eine Taschenlampenfunktion der Handbedienung 1 ist nicht dargestellt, aber leicht vorstellbar. Dazu ist z.B. eine leuchtstarke Leuchtdiode oder ein Leuchtdiodenarray vorgesehen, welches durch eine Betätigungsfläche 4 ein- und ausschaltbar ist.

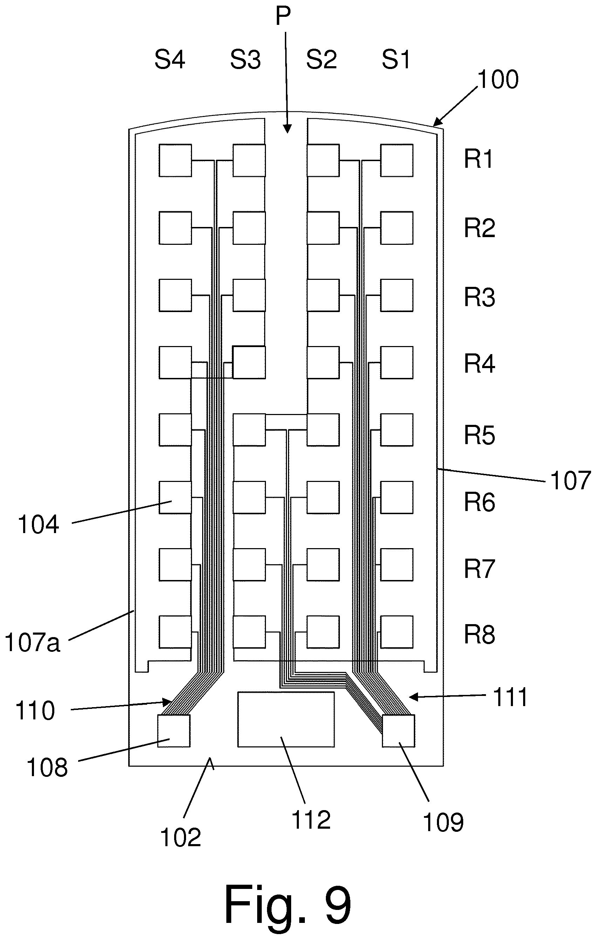

In Figur 8 ist eine schematische Draufsicht auf eine Betätigungsseite 101 einer Detektorplatine 100 dargestellt. Figur 9 zeigt eine schematische Draufsicht auf eine Bestückungsseite 102 der Detektorplatine 100 nach Figur 8.

Die Detektorplatine 100 ist in diesem Beispiel eine doppelseitige Leiterplatte und umfasst die Detektoren 103, Masseflächen 106-106a und 107-107a , Detektorleiterbahnen 110, 111 und mindestens eine Auswerteeinheit 108, 109.

Die Detektoren 103 weisen jeweils mindestens eine Sensorfläche 105 auf und sind in Reihen und Spalten auf der Betätigungsseite 101 der Detektorplatine 100 angeordnet. Zur besseren Orientierung werden die Spalten S1...4 von links nach rechts und die Reihen R1...8 von oben nach unten auf der Betätigungsseite (Figur 8) benannt.

Hier sind zweiunddreißig Detektoren 103 vorgesehen. Jede Sensorfläche 105 ist als ein rechteckiger, insbesondere quadratischer, elektrisch leitender Rahmen ausgebildet. Dabei besteht jede Sensorfläche 105 aus einer entsprechend geformten Leiterbahn der Leiterplatte und ist über jeweils eine der Detektorleiterbahnen 110, 111 mit einer Auswerteeinheit 108, 109 elektrisch verbunden.

In diesem Beispiel sind in den von den Sensorflächen 105 eingeschlossenen Abschnitten Durchgangslöcher 104 eingeformt. Sie werden unten noch weiter erläutert.

Die Sensorflächen 105 sind auf der Betätigungsseite 101 von zwei Masseflächen 106 und 106a zumindest teilweise vollständig umgeben und von den Masseflächen 106 und 106a elektrisch isoliert. Dabei sind hier auf der linken Seite der Betätigungsseite 101 die Sensorflächen 105 der Spalte S1, die untersten vier Sensorflächen 105 der Reihen R5-8 der zweiten Spalte S2 und die Sensorflächen 105 der Reihen R1-4 der vierten Spalte S4 alle von Masseflächen 106-106a vollständig, d.h. an allen vier Seiten, umgeben. Die Sensorflächen 105 der Reihen R1-4 der Spalte S2, der Reihen R1-3 und R6-8 der Spalte S3 und die Reihen R5-8 der Spalte S4 sind nur an drei Seiten von Massenflächen 106-106a umgeben, wobei die Sensorflächen 105 der Reihen R4-5 der Spalte S3 nur an zwei Seiten von Massenflächen 106-106a umgeben sind.

Auf der Betätigungsseite 101 sind die zwei Masseflächen 106 und 106a durch einen Pfad P voneinander getrennt angeordnet. Der Pfad P verläuft von oben zunächst zwischen den Sensorflächen 105 der Spalten S2 und S3 über die Reihen R4 senkrecht nach unten. Dann verläuft der Pfad P rechtwinklig nach rechts zwischen den Reihen R4-5 bis zur Spalte S4 und weiterhin rechtwinklig nach unten zwischen den Spalten S3 und S4 über die Reihen R5-8.

Der ersten Massefläche 106 sind hier zwanzig Detektoren 103 zugeordnet, und die zweite Massefläche 106a ist mit zwölf Detektoren 103 verknüpft.

Die Detektorplatine 100 wird mit der Betätigungsseite 101 in ein zugehöriges Gehäuse 2 unter den Bedienfeldabschnitten 3 und Bedienflächen 4 (siehe z.B. Figur 3) angeordnet, z.B. eingeklebt.

Auch auf der Bestückungsseite 102 sind ebenfalls zwei Masseflächen 107 und 107a in gleicher Konfiguration, Geometrie und Anordnung wie auf der Betätigungsseite 101 angeordnet. Dabei entspricht die erste Massefläche 107 der Bestückungsseite 102 der ersten Massefläche 106 der Betätigungsseite 101, und die zweite Massefläche 107a der Bestückungsseite 102 der zweiten Massefläche 107a der Betätigungsseite 101.

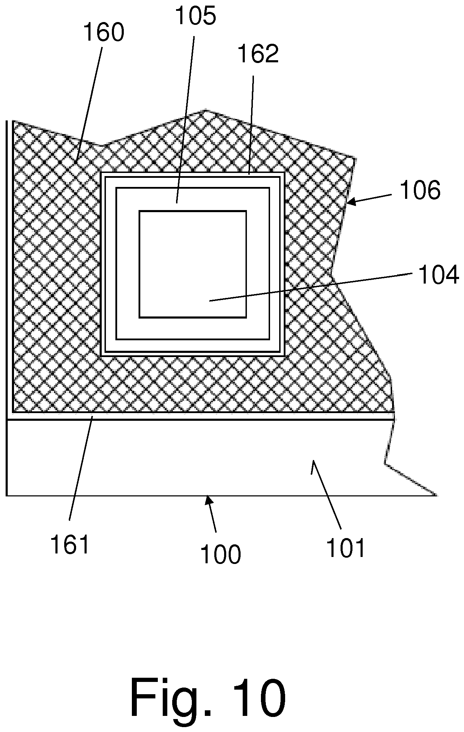

Die Masseflächen 106-106a und 107-107a können in spezieller Ausgestaltung statt mit einer durchgehenden Fläche mit einem Kreuzmuster 160 ausgebildet sein. Dies ist in Figur 10 in einer vergrößerte Darstellung eines Ausschnitts X der Massefläche 106 nach Figur 8 schematisch dargestellt. Die Massefläche 106 ist mit einem Rand 161 umgeben, wobei ein weiterer Rand 162 die Sensorfläche 105 umgibt.

Auf der Bestückungsseite 102 der Detektorplatine 100 sind hier zwei Auswerteeinheiten 108 und 109 neben einer Verbindungseinheit 112 angeordnet. Die erste Auswerteeinheit 108 ist hier mit den schon oben genannten zwölf Sensorflächen 105 über zwölf Detektorleitungen 110 elektrisch leitend verbunden, wobei die zweite Auswerteeinheit 109 mit zwanzig Detektorleitungen 111 hier mit den schon oben genannten zwanzig Sensorflächen 105 elektrisch leitend verbunden ist.

Die Detektorleitungen 110 sind von den beiden Masseflächen 107 und 107a , welche sie durchlaufen, elektrisch isoliert. Elektrisch leitende Verbindungen mit der jeweiligen Sensorfläche 105 sind hier mittels entsprechender Durchkontaktierungen der Detektorplatine 100 ausgebildet.

Weiterhin ist auf der Bestückungsseite 102 der Detektorplatine 100 eine Verbindungseinheit 112 vorgesehen, welche in Figur 9 unten zwischen den Auswerteeinheiten 108, 109 angeordnet und als Steckverbindung ausgebildet ist. Eine nicht gezeigte elektrische Verbindungsleitung verbindet die Detektorplatine 100 mit einer Steuerplatine 200, wobei diese Verbindungsleitung eine elektrisch leitende Verbindung mit der Verbindungseinheit 112 der Detektorplatine 100 und einer Verbindungseinheit 212 der Steuerplatine 200 bildet.

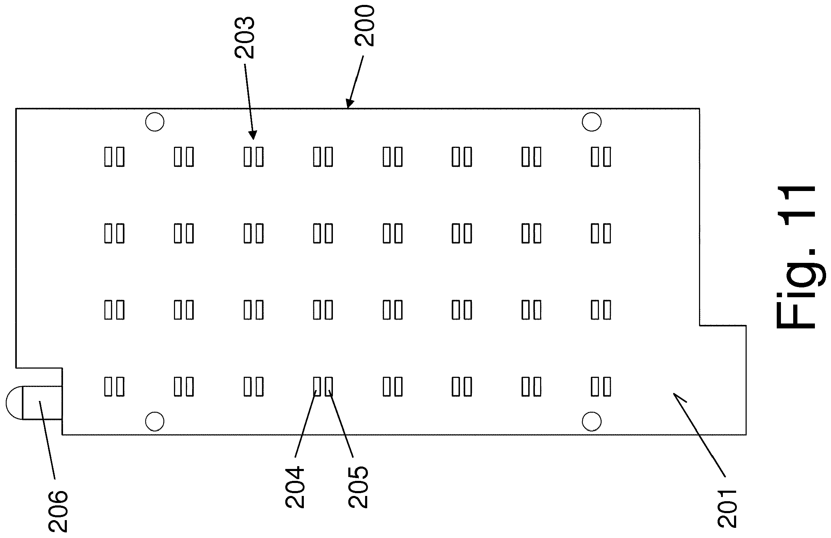

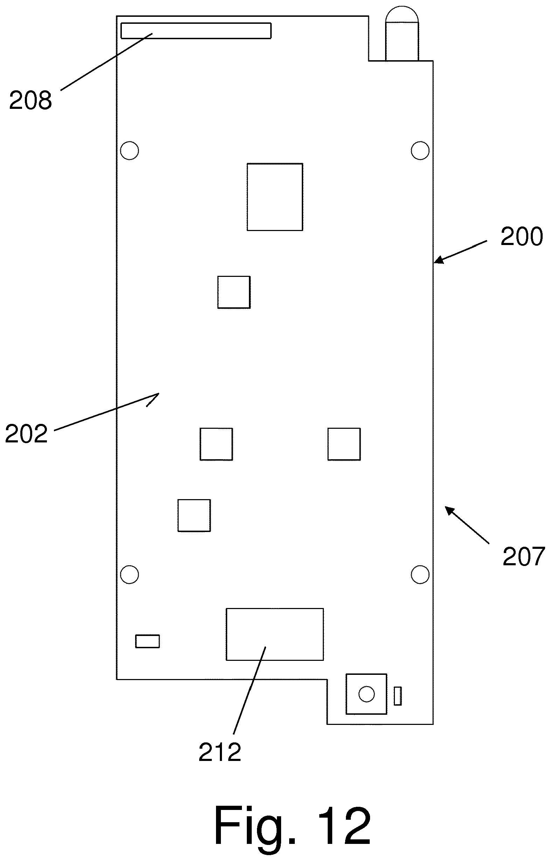

Figur 11 stellt eine schematische Draufsicht auf eine Oberseite 201 einer Steuerplatine 200 dar. In Figur 12 ist eine schematische Draufsicht auf eine Bestückungsseite 202 der Steuerplatine 200 nach Figur 11 gezeigt.

Die Steuerplatine 200 ist eine doppelseitige Leiterplatte und umfasst Leuchteneinheiten 203, eine Steuereinrichtung 207 und eine Verbindungseinheit 212. Als Sende- und Empfangselement zur Kommunikation mit einer Steuerung eines elektromotorischen Möbelantriebs kann die Steuerplatine 200 ein Sendeelement 206, z.B. für eine Infrarotübertragungsstrecke, oder/und eine Antenne 208 für eine Funkübertragungsstrecke aufweisen. Denkbar ist auch ein Anschluss für eine drahtgebundene Übertragungsstrecke. Dazu gehören selbstverständlich die erforderlichen Sende- und Empfangsschaltungen für die verschiedenen Übertragungsstrecken.

Auf der Oberseite 201 der Steuerplatine 200 sind die Leuchteneinheiten 203 angeordnet. Deren Anordnung ist entsprechend der Anordnung der Detektoren 103 auf der Detektorplatine 100 gewählt. Jede Leuchteneinheit 203 weist hier zwei Leuchtelemente 204, 205 auf, beispielsweise Leuchtdioden (LED) mit unterschiedlichen Farben. Die Steuerplatine 200 wird in einem bestimmten Abstand zu der Detektorplatine 100 auf dieser mit entsprechenden Abstandshaltern und Befestigungsmitteln aufgebracht. Dies erfolgt dergestalt, dass sich jeweils eine Leuchteneinheit 203 über bzw. unter einem Durchgangsloch 104 des jeweils zugehörigen Detektors 103 befindet.

Auf diese Weise kann ein Symbol bzw. ein über dem jeweiligen Detektor 103 angeordnete Betätigungsfläche 4 von der zugehörigen Leuchteneinheit 203 direkt oder indirekt beleuchtet werden, um bestimmte Betriebszustände der zugehörigen Funktion darzustellen, oder auch nur, um eine Beleuchtung zu bilden.

Hierbei gibt es unterschiedliche Möglichkeiten. So kann z.B. das erste Leuchtelement 204 als einfarbige LED eine Basisbeleuchtung bilden und das zweite Leuchtelement 205 als Betätigungsquittung verwendet werden. Die Basisbeleuchtung ist z.B. weiß. Das zweite Leuchtelement 205 kann beispielsweise eine zweifarbige LED sein, wobei zwei unterschiedliche Betätigungsquittungsfarben möglich sind, z.B. grün oder gelb als erste Farbe und blau als zweite Farbe.

Die beiden Leuchtelemente 204 und 205 können als eine mehrfarbige LED ausgebildet sein.

Die ersten Leuchtelemente 204 können als Gruppen zusammengefasst sein.

Auf der Bestückungsseite 202 der Steuerplatine 200 sind die Steuereinrichtung 207, die Antenne 208 und die Verbindungseinheit 212 angeordnet.

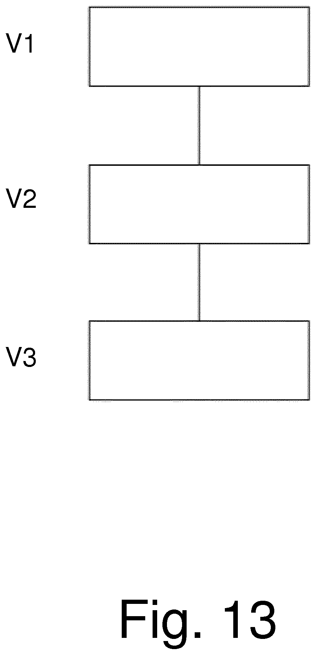

Die Funktion der Detektoren 103 und deren Auswertung werden nun im Zusammenhang mit Figur 13 beschrieben. Figur 13 zeigt dazu ein schematisches Flussdiagramm eines erfindungsgemäßen Verfahrens.

Die Masseflächen 106-106a und 107-107a bilden eine Referenz zu den Sensorflächen 105, wobei eine Kapazität der so gebildeten Kondensatoren durch eine Betätigung verändert wird. Diese Kapazitätsänderung wird von der Auswerteeinheit 108, 109 erfasst.

In einem ersten Verfahrensschritt V1 werden die Sensorflächen 105 der Detektoren 103 jeweils mit einem elektrischen, periodischen Testsignal von den Auswerteeinheiten 108, 109 über die Detektorleiterbahnen 110, 111 beaufschlagt. Ein solches Testsignal wird von den Auswerteeinheiten 108, 109 der Reihe nach auf die Sensorflächen 105 der Detektoren 103 aufgebracht. Beim Berühren einer Betätigungsfläche 4 oberhalb der zugehörigen Sensorfläche 105 des entsprechenden Detektors 103 verändert sich der Charakter des zugehörigen Testsignals, was als ein Antwortsignal bezeichnet wird. Dies wird von der zugehörigen Auswerteeinheit 108, 109 in einem zweiten Verfahrensschritt V2 aufgenommen.

Dabei kann durch die Auswerteeinheit 108, 109 physikalisch eine durch Berührung der Betätigungsfläche 4 und somit Kapazitätsänderung von ca. 1 pF an der Sensorfläche 105 als Antwortsignal erfasst werden, wobei eine Eigenkapazität der Detektorleiterbahnen 110, 111 von ca. 1 pF/cm von den Auswerteeinheiten 108, 109 in entsprechender Weise ausgeblendet wird.

In einem dritten Verfahrensschritt V3 wird das jeweilige Antwortsignal eines Detektors 103 von den Auswerteeinheiten 108, 109 ausgewertet und ein entsprechendes logisches Schaltsignal gebildet, das daraufhin an die Steuereinrichtung 207 weitergeleitet wird. Die Steuereinrichtung 207 erzeugt ein entsprechendes Funktionsbefehlsignal zur Übertragung über die Übertragungsstrecke an den zugeordneten elektromotorischen Möbelantrieb.

In dem dritten Verfahrensschritt V3 wird in einer ersten Variante aus dem Antwortsignal direkt ein logisches Schaltsignal gebildet.

In einer zweiten Variante vergleichen die Auswerteeinheiten 108, 109 gemeinschaftlich alle Antwortsignale, wobei das Antwortsignal mit dem höchsten Signalpegel zur Weiterleitung an die Steuereinrichtung 207 verwertet wird.

Bei einer dritten Variante geben alle Auswerteeinheiten 108, 109 einen Ausgabewert korrespondierend mit dem Signalpegel des Antwortsignals an die Steuereinrichtung 207 weiter. Dann ermittelt die Steuereinrichtung 207, welche Sensorfläche 105 eines Detektors 103 dazu gehört. Liefern beispielsweise fünf Sensorflächen 105 ein gleiches oder ähnliches Antwortsignal, so wird die geometrische Anordnung der Sensorflächen 105 der Detektoren 103 berücksichtigt und die geometrisch am nächsten gelegene Sensorfläche 105 als diejenige festgelegt, deren Funktion ein Bediener beabsichtigt hat. Die Steuereinrichtung 207 umfasst mindestens einen Controller, z.B. einen Mikrocomputer, mit einer entsprechenden Software.

Physikalische Beeinflussungen, die Störungen bewirken können, werden durch Software und weitere Maßnahmen unterdrückt. Dies ist z.B. durch verschiedene Tests zuvor möglich, wobei bei für die erste und zweite Variante festgelegt wird, welche Höhe des Signalpegels des Antwortsignals einer jeweiligen Sensorfläche 105 eines Detektors 103 einer zugehörigen Betätigung entspricht. Dazu können verschiedene Kalibrier- bzw. Einstellroutinen der Software der Steuereinrichtung 207 verwendet werden.

Zudem kann eine Selbstkalibrierung der Auswerteeinheit 108, 109 erfolgen. Dabei wird mittels verschiedener, mehrfacher Abläufe die aktive Sensorfläche 105 ermittelt. Dieser Prozess kann natürlich auch selbstlernend sein.

Es hat sich überraschenderweise gezeigt, dass auf diese Weise eine zufriedenstellende Bedienungsfunktion ermöglicht wird.

Die erfindungsgemäße Handbedienung 1 kann zusammen mit einem elektromotorischen Möbelantrieb zur Verstellung von zu verstellenden Bauteilen eines Möbels verwendet werden, wobei die Handbedienung 1 zur Bedienung der Verstellfunktionen und möglichen weiteren Funktionen des elektromotorischen Möbelantriebs vorgesehen ist.

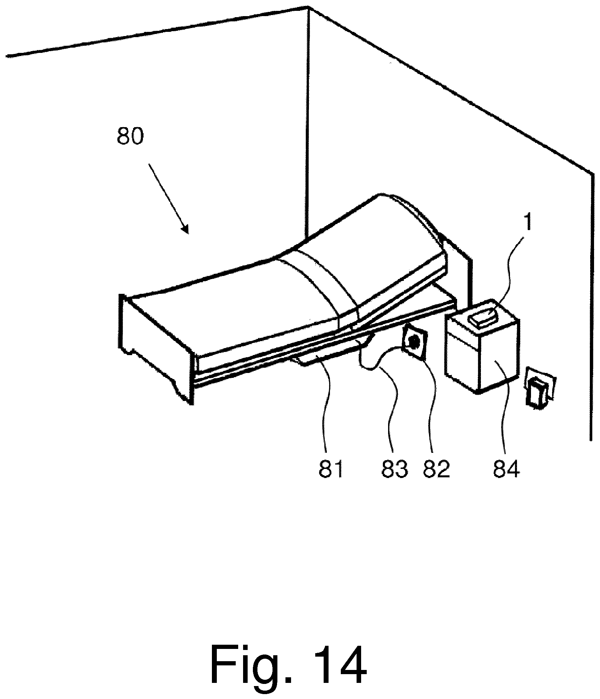

Figur 14 zeigt eine schematische Perspektivdarstellung eines Ausführungsbeispiels einer Handbedienung 1 mit einem beispielhaften Möbel 80, welches hier als Bett ausgebildet ist. Das Möbel 80 umfasst einen elektromotorischen Möbelantrieb 81, welcher mit dem Möbel 80 verbunden ist und bewegliche Möbelbauteile des Möbels 80 motorisch verstellt. Dabei weist der zumindest eine Möbelantrieb 81 ein durch einen Elektromotor betriebenes Abtriebsglied auf, welches über Funktionsbeschläge mittelbar oder unmittelbar mit beweglichen oder alternativ mit festen Möbelbauteilen in mechanischer Wirkverbindung steht, und sich zumindest bei Betrieb des jeweiligen Elektromotors das jeweilige Möbelbauteil relativ zu einem anderen Möbelbauteil bewegt.

Gemäß der Darstellung der Figur 8 ist das Rückenteil des als Bett ausgebildeten Möbels 80 von der Grundposition heraus etwas nach oben verstellt. Zur Stromversorgung des Möbelantriebs 81 ist hier ein gebäudeseitiger Netzanschluss 82 vorgesehen. Über eine Leitung 83 wird der Möbelantrieb 81 mit elektrischer Energie über den Netzanschluss 82 aus dem elektrischen Netz versorgt. Alternativ kann der Möbelantrieb 81 auch eine netzunabhängige Stromversorgung in Form eines Akkumulators umfassen.

Ferner ist die Handbedienung 1 zur Bedienung des Möbelantriebs 81 vorgesehen und beispielsweise auf eine Ablage 84 bis zur weiteren Verwendung durch einen Benutzer abgelegt. In dieser Ausführung sind Handbedienung 1 und Möbelantrieb 81 zur drahtlosen Kommunikation untereinander ausgebildet. Dazu weist die Handbedienung 1 zumindest eine Sendeeinrichtung auf, während der Möbelantrieb 81 eine Empfangseinrichtung umfasst. Alternativ umfassen Handbedienung 1 und Möbelantrieb 81 jeweils eine Sendeeinrichtung und eine Empfangseinrichtung, wenn sie in einer drahtlosen und bidirektionalen Übertragungsstrecke miteinander in Kommunikationsverbindung stehen. Eine erste Sendeeinrichtung ist durch eine funkwellenübertragende Funksendeeinrichtung gebildet. Eine weitere Sendeeinrichtung ist durch eine lichtwellenübertragende Infrarotlichtsendeeinrichtung gebildet.

Die Erfindung ist durch die oben beschriebenen Ausführungsbeispiele nicht eingeschränkt, sondern sie ist im Rahmen der beigefügten Ansprüche modifizierbar.

Die Detektorplatine 100 kann auch für andere Anzahlen von Detektoren 103 ausgelegt sein, z.B. für zwanzig Detektoren 103. Dabei ist z.B. nur die zweite Auswerteeinheit 109 erforderlich.

Anstelle eines Kreuzmusters der Masseflächen 106-106a und 107-107a können diese auch mit einem anderen Muster versehen sein. Außerdem ist es möglich, dass die Masseflächen 106-106a und 107-107a nur zum Teil mit einem Muster versehen sind und sonst durchgehend flächig ausgebildet sind.

Die Detektorplatine 100 und die Steuerplatine 200 können natürlich auch als Multilayerplatinen ausgebildet sein.

Es ist natürlich auch denkbar, dass die Detektorplatine 100 und die Steuerplatine 200 eine gemeinsame Platine bilden, wobei die Bauteile der Detektorplatine 100 und der Steuerplatine 200 auf der gemeinsamen Platine angeordnet sind.

Weiterhin ist es im Falle von mehr als wenigstens zwei Platinen, z.B. Detektorplatine 100, Steuerplatinen 200 oder/und eine Beleuchtungsplatine (nicht gezeigt) möglich, dass diese Platinen über Steckverbinder, Stapelleisten oder dgl. elektrisch und auch mechanisch untereinander verbunden sind.

Die Leuchteneinheiten 203 können auch auf der Sensorplatine 100 angeordnet sein. Auch eine Kombination der Anordnung auf der Sensorplatine 100 und der Steuerplatine 200 ist denkbar.

Die Sensorfläche 105 kann auch ein offener Rahmen sein. Die Form der Sensorfläche 105 kann auch kreisrund, oval, eckig sein oder aus Kombinationen davon bestehen.

### Bezugszeichenliste

- 1: Handbedienung
- 2: Gehäuse
- 3, 3a, 3b: Bedienfeldabschnitt
- 4: Betätigungsfläche
- 5: Vorderseite (Bedienungssseite)
- 6: Rückseite
- 7: Anzeigeeinrichtung
- 7a: Anzeigemuster
- 8: Betätigungsfläche
- 8a: Quittungsbetätiger
- 8b, 8c: Funktionsbetätiger
- 8d, 8e: Menübetätiger
- 80: Möbel
- 81: Möbelantrieb
- 82: Netzanschluss
- 83: Leitung
- 84: Ablage
- 100: Detektorplatine
- 101: Betätigungsseite
- 102: Bestückungsseite
- 103: Detektor
- 104: Durchgangsloch
- 105: Sensorfläche
- 106-106a; 107-107a: Massefläche
- 108, 109: Auswerteeinheit
- 110, 111: Detektorleiterbahn
- 112, 212: Verbindungseinheit
- 160: Muster
- 161, 162: Rand
- 200: Steuerplatine
- 201: Oberseite
- 202: Bestückungsseite
- 203: Leuchteneinheit
- 204,205: Leuchtelement
- 206: Sendeelement
- 207: Steuereinrichtung
- 208: Antenne
- P: Pfad
- R1...8: Reihe
- S1...4: Spalte
- V1...3: Verfahrensschritt

## Patentansprüche

1. Handbedienung (1) für elektromotorische Möbelantriebe (81), mit mindestens einem Bedienfeldabschnitt (3, 3a, 3b) mit einer festen, nicht nachgiebigen Oberfläche wobei der mindestens eine Bedienfeldabschnitt (3, 3a, 3b) mindestens eine Betätigungsfläche (4) aufweist, sowie wenigstens einem Detektor (103), wobei die mindestens eine Betätigungsfläche (4) mit dem wenigstens einem Detektor (103) so zusammenwirkt, dass die mindestens eine Betätigungsfläche (4) mindestens eine berührungsempfindliche Funktion aufweist, wobei jeder der Betätigungsflächen (4) einer der Detektoren (103) zugeordnet ist, welcher im Inneren des Gehäuses der Handbedienung angeordnet ist, wobei der mindestens eine Bedienfeldabschnitt (3, 3a, 3b) mehrere Betätigungsflächen (4) aufweist, welche in einem vorbestimmten Abstand zueinander angeordnet sind, **dadurch gekennzeichnet, dass**
die Handbedienung (1) eine Detektorplatine (100) mit dem wenigstens einem Detektor (103) aufweist, und dass der wenigstens eine Detektor (103) wenigstens eine Sensorfläche (105) umfasst, der wenigstens eine Massefläche (106, 106a; 107, 107a) zugeordnet ist, wobei die wenigstens eine Sensorfläche (105) mit der wenigstens einen zugeordneten Massefläche (106, 106a; 107, 107a) mit wenigstens einer Auswerteeinheit (108, 109) elektrisch leitend verbunden ist, wobei die wenigstens eine Sensorfläche (105) als ein elektrisch leitender Rahmen ausgebildet ist und ein Durchgangsloch (104) wenigstens teilweise umgibt.

2. Handbedienung (1) nach Anspruch 1, bei der der elektrisch leitende Rahmen rechteckig und insbesondere quadratisch ist.

3. Handbedienung (1) nach Anspruch 1 oder 2, **dadurch gekennzeichnet, dass** die wenigstens eine Sensorfläche (105) von der wenigstens einen Massefläche (106, 106a; 107, 107a) wenigstens teilweise vollständig umgeben ist.

4. Handbedienung (1) nach einem oder mehreren der Ansprüche 1 bis 3, **dadurch gekennzeichnet, dass** die wenigstens eine Massefläche (106, 106a; 107, 107a) wenigstens ein mit einem Rand (161, 162) umgebenes Kreuzmuster (160) aufweist.

5. Handbedienung (1) nach einem oder mehreren der vorhergehenden Ansprüche, **dadurch gekennzeichnet, dass** die Handbedienung (1) wenigstens eine Steuereinrichtung (207) zur Erzeugung eines Steuersignals aufweist.

6. Verfahren zum Erfassen einer Betätigung einer Handbedienung (1) nach einem oder mehreren der vorhergehenden Ansprüche, **gekennzeichnet durch** die Verfahrensschritte
(V1) Beaufschlagen wenigstens einer Sensorfläche (105) wenigstens eines Detektors (103) mit einem elektrischen, periodischen Testsignal von wenigstens einer Auswerteeinheit (108, 109);
(V2) Aufnehmen eines Antwortsignals anhand eines durch Betätigung des wenigstens einen Detektors (103) veränderten Testsignals; und
(V3) Auswerten des so erhaltenen Testsignals und Erzeugen eines logischen Schaltsignals zum Erfassen der Betätigung der Handbedienung (1).

7. Verfahren nach Anspruch 6, **dadurch gekennzeichnet, dass** in dem dritten Verfahrensschritt (V3) Auswerten aus dem Antwortsignal direkt ein logisches Schaltsignal gebildet wird.

8. Verfahren nach Anspruch 6, **dadurch gekennzeichnet, dass** in dem dritten Verfahrensschritt (V3) Auswerten die wenigstens eine Auswerteeinheit (108, 109) alle Antwortsignale vergleicht, wobei das Antwortsignal mit dem höchsten Signalpegel zur Weiterleitung an eine Steuereinrichtung (207) der Handbedienung (1) verwertet wird.

9. Verfahren nach Anspruch 6, **dadurch gekennzeichnet, dass** in dem dritten Verfahrensschritt (V3) Auswerten die wenigstens eine Auswerteeinheit (108, 109) einen Ausgabewert korrespondierend mit dem Signalpegel des Antwortsignals an eine Steuereinrichtung (207) weiterleitet.

10. Verfahren nach Anspruch 9, **dadurch gekennzeichnet, dass** die Steuereinrichtung (207) bei mehreren aufgenommenen gleichen oder ähnlichen Antwortsignalen eine geometrische Anordnung der Sensorflächen (105), welche die Antwortsignale geliefert haben, berücksichtigt, wobei sie die geometrisch am nächsten gelegene Sensorfläche (105) als diejenige festgelegt, deren Funktion ein Bediener beabsichtigt hat.

11. Verfahren nach einem oder mehreren der Ansprüche 6 bis 9, **dadurch gekennzeichnet, dass** eine Höhe des Signalpegels des Antwortsignals einer jeweiligen Sensorfläche (105) eines Detektors (103) einer zugehörigen Betätigung vorher zugeordnet wird.

12. Elektromotorischer Möbelantrieb (81) zur Verstellung von beweglichen Bauteilen eines Möbels (80), **dadurch gekennzeichnet,**
**dass** der elektromotorische Möbelantrieb (81) mit mindestens einer Handbedienung (1) nach einem oder mehreren der Ansprüche 1 bis 5 zur Bedienung ausgerüstet ist, wobei eine Betätigung der Handbedienung (1) durch ein Verfahren nach einem oder mehreren der Ansprüche 6 bis 11 erfasst wird.

## Claims

1. Hand-held control (1) for electromotive furniture drives (81), having at least one control panel section (3, 3a, 3b) with a firm, non-resilient surface, wherein the at least one control panel section (3, 3a, 3b) comprises at least one actuation surface (4) and at least one detector (103), wherein the at least one actuation surface (4) cooperates with the at least one detector (103) so that the at least one actuation surface (4) has at least one touch-sensitive function, wherein to each of the actuation surfaces (4) is assigned one of the detectors (103) which is arranged within a housing of the hand-held control, wherein the at least one control panel section (3, 3a, 3b) comprises a plurality of actuation surfaces (4) that are arranged at a predetermined distance from one another, **characterized in that**
the hand-held control (1) has a detector printed circuit board (100) with the at least one detector (103), and that the at least one detector (103) comprises at least one sensor surface (105) to which is assigned at least one ground plane (106, 106a; 107, 107a), wherein the at least one sensor surface (105) with the at least one associated ground plane (106, 106a; 107, 107a) is connected in an electrically conducting manner to at least one evaluation unit (108, 109), wherein the at least one sensor surface (105) is configured as an electrically conducting frame and at least partially surrounds a through hole (104).

2. The hand-held control (1) according to claim 1, wherein the electrically conducting frame has a rectangular shape, in particular a square shape.

3. The hand-held control (1) according to claim 1 or 2, **characterized in that** the at least one sensor surface (105) is at least partially completely surrounded by the at least one ground plane (106, 106a; 107, 107a).

4. The hand-held control (1) according to any one or more of claims 1 to 3, **characterized in that** the at least one ground plane (106, 106a; 107, 107a) comprises at least one cross pattern (160) surrounded by an edge (161, 162) .

5. The hand-held control (1) according to any one or more of the preceding claims, **characterized in that** the hand-held control (1) comprises at least one control device (207) for generating a control signal.

6. Method for detecting an actuation of a hand-held control (1) according to any one or more of the preceding claims, **characterized by** the process steps
(V1) applying an electric periodic test signal from at least one evaluation unit (108, 109) to at least one sensor surface (105) of at least one detector (103);
(V2) recording a response signal by means of a test signal modified by actuation of the at least one detector (103); and
(V3) evaluating the test signal thus obtained and producing a logic switching signal for detecting the actuation of the hand-held control (1).

7. The method according to claim 6, **characterized in that** in the third process step (V3) - evaluating - a logic switching signal is formed directly from the response signal.

8. The method according to claim 6, **characterized in that** in the third process step (V3) - evaluating -, the at least one evaluation unit (108, 109) compares all the response signals, wherein the response signal having the highest signal level is used for relaying to a control device (207) of the hand-held control (1).

9. The method according to claim 6, **characterized in that** in the third process step (V3) evaluation, the at least one evaluation unit (108, 109) relays an output value corresponding to the signal level of the response signal to a control device (207).

10. The method according to claim 9, **characterized in that** if there are a plurality of recorded identical or similar response signals, the control device (207) takes into account a geometrical arrangement of the sensor surfaces (105) that have delivered the response signals, wherein it specifies the geometrically nearest sensor surface (105) as the one whose function an operator has intended.

11. The method according to any one or more of claims 6 to 9, **characterized in that** a height of the signal level of the response signal of a respective sensor surface (105) of a detector (103) is previously assigned to a related actuation.

12. Electromotive furniture drive (81) for adjustment of movable components of an item of furniture (80), **characterized in that** the electromotive furniture drive (81) is fitted with at least one hand-held control (1) according to any one or more of claims 1 to 5, wherein an actuation of the hand-held control (1) is detected by a method according to any one or more of claims 6 to 11.

## Revendications

1. Commande manuelle (1) pour des entraînements de meuble (81) à moteur électrique, avec au moins une partie formant un panneau de commande (3, 3a, 3b) à surface solide et non souple, laquelle au moins une partie formant un panneau de commande (3, 3a, 3b) présente au moins une surface d'actionnement (4), et avec au moins un détecteur (103), l'au moins une surface d'actionnement (4) coopérant avec l'au moins un détecteur (103) de telle manière que l'au moins une surface d'actionnement (4) présente au moins une fonction tactile, chacune des surfaces d'actionnement (4) étant associée à un des détecteurs (103) qui est disposé à l'intérieur du boîtier de la commande manuelle, dans laquelle l'au moins une partie formant un panneau de commande (3, 3a, 3b) comprend plusieurs surfaces d'actionnement (4) qui sont disposées à une distance prédéterminée les unes des autres, **caractérisée en ce que** la commande manuelle (1) comprend une carte de détecteur (100) avec l'au moins un détecteur (103) et **en ce que** l'au moins un détecteur (103) comprend au moins une surface de capteur (105) à laquelle est associée au moins une surface de masse (106, 106a; 107, 107a), l'au moins une surface de capteur (105) avec l'au moins une surface de masse (106, 106a ; 107, 107a) associée étant reliée de façon conductrice électrique à au moins une unité d'analyse (108, 109), l'au moins une surface de capteur (105) étant réalisée comme un cadre conducteur électrique et entourant au moins en partie un trou traversant (104).

2. Commande manuelle (1) selon la revendication 1, dans laquelle le cadre conducteur électrique est rectangulaire, en particulier carré.

3. Commande manuelle (1) selon la revendication 1 ou 2, **caractérisée en ce que** l'au moins une surface de capteur (105) est complètement entourée au moins partiellement par l'au moins une surface de masse (106, 106a ; 107, 107a).

4. Commande manuelle (1) selon une ou plusieurs des revendications 1 à 3, **caractérisée en ce que** l'au moins une surface de masse (106, 106a ; 107, 107a) comprend au moins un motif en croix (160) entouré par un bord (161, 162).

5. Commande manuelle (1) selon une ou plusieurs des revendications précédentes, **caractérisée en ce que** la commande manuelle (1) comprend au moins un dispositif de contrôle (207) destiné à produire un signal de contrôle.

6. Procédé pour détecter un actionnement d'une commande manuelle (1) selon une ou plusieurs des revendications précédentes, **caractérisé en ce qu'**il comprend les étapes de
(V1) application à au moins une surface de capteur (105) d'au moins un détecteur (103) d'un signal de test électrique périodique d'au moins une unité d'analyse (108, 109) ;
(V2) acquisition d'un signal de réponse à l'aide d'un signal de test modifié par l'actionnement de l'au moins un détecteur (103) et
(V3) analyse du signal de test ainsi reçu et production d'un signal de commutation logique pour détecter l'actionnement de la commande manuelle (1).

7. Procédé selon la revendication 6, **caractérisé en ce que** dans l'étape d'analyse qui est la troisième étape du procédé (V3), un signal de commutation logique est directement formé à partir du signal de réponse.

8. Procédé selon la revendication 6, **caractérisé en ce que** dans l'étape d'analyse qui est la troisième étape du procédé (V3), l'au moins une unité d'analyse (108, 109) compare tous les signaux de réponse, le signal de réponse qui a le niveau de signal le plus élevé étant analysé pour être transmis à un dispositif de contrôle (207) de la commande manuelle (1).

9. Procédé selon la revendication 6, **caractérisé en ce que** dans l'étape d'analyse qui est la troisième étape du procédé (V3), l'au moins une unité d'analyse (108, 109) transmet une valeur de sortie correspondant au niveau de signal du signal de réponse à un dispositif de contrôle (207).

10. Procédé selon la revendication 9, **caractérisé en ce que**, si plusieurs signaux de réponse identiques ou similaires sont captés, le dispositif de contrôle (207) tient compte d'une disposition géométrique des surfaces de capteur (105) qui ont fourni les signaux de réponse, en définissant la surface de capteur (105) la plus proche géométriquement comme celle qu'un utilisateur a voulu faire fonctionner.

11. Procédé selon une ou plusieurs des revendications 6 à 9, **caractérisé en ce qu'**une hauteur du niveau du signal de réponse d'une surface de capteur (105) respective d'un détecteur (103) est associée à l'avance à un actionnement correspondant.

12. Entraînement de meuble (81) à moteur électrique pour le déplacement de composants mobiles d'un meuble (80), **caractérisé en ce que** l'entraînement de meuble (81) à moteur électrique est équipé d'au moins une commande manuelle (1) selon une ou plusieurs des revendications 1 à 5 pour la commande, un actionnement de la commande manuelle (1) étant détecté par un procédé selon une ou plusieurs des revendications 6 à 11.
